# FASCICULE DE BREVET EUROPEEN

(11) **EP 2 795 410 B1**
(45) Date de publication et mention de la délivrance du brevet: **29.06.2022**
(21) Numéro de dépôt: 12810282.9
(22) Date de dépôt: 20.12.2012
(51) Int. Cl.: G04B 31/02, B23K 26/57, B81C 1/00, G04B 15/14, G04B 31/06, G04B 31/08, G04B 31/004

(54) **PALETTE ET SON PROCEDE DE REALISATION**
PALETTE UND HERSTELLUNGVERFAHREN EINER PALETTE
PALLET-STONE AND ITS MANUFACTURING METHOD

(30) Priorité: 22.12.2011 EP 11195421
(43) Date de publication de la demande: 29.10.2014
(73) Titulaire: The Swatch Group Research and Development Ltd., 2074 Marin (CH)
(72) Inventeur: HESSLER, Thierry, 2024 St-Aubin (CH); REBEAUD, Nicolas, 1052 Le Mont-sur-Lausanne (CH); HELFER, Jean-Luc, 2525 Le Landeron (CH); RICHARD, David, 1400 Yverdon-les-Bains (CH); GRAF, Sébastien, 1052 Le Mont-sur-Lausanne (CH)
(74) Mandataire: Collé, Emmanuel
(86) Numéro de dépôt international: PCT/EP2012/076502
(87) Numéro de publication internationale: WO 2013/092924

(56) Documents cités:
- EP-A1- 1 791 039
- EP-A1- 1 818 736
- EP-A2- 2 015 147
- CH-A- 321 946
- CH-A2- 700 528
- CH-A5- 690 013
- US-A1- 2002 139 769
- US-A1- 2003 235 385
- US-A1- 2011 034 031
- US-A1- 2011 127 883

## Description

L'invention concerne une palette d'ancre d'horlogerie, comprenant au moins un évidement s'étendant dans ladite palette à partir d'au moins une de ses surfaces.

### ARRIERE PLAN TECHNOLOGIQUE

Il est connu de l'art antérieur que certaines pièces de microtechnique en matériaux de type monocristallin ou polycristallin sont réalisées par gravure chimique. Cette technique consiste à se munir du substrat à graver, et à déposer une couche de résine photosensible dessus. Sur cette résine est placé un masque puis le tout est exposé à de la lumière afin que la structure de la résine photosensible exposée à la lumière soit modifiée. Cette résine modifiée est éliminée par action d'un élément chimique laissant alors le substrat à nu aux endroits où la résine a été éliminée.

Par la suite ces zones à nu du substrat sont attaquées chimiquement afin de les creuser. L'agent chimique est choisi pour attaquer seulement le matériau composant le substrat et non la résine photosensible non modifiée. La durée de cette étape de gravure chimique permet de déterminer les dimensions des creusures.

De même, il est envisageable que des pièces de microtechnique soient réalisées par usinage et/ou polissage de sorte qu'un foret ou une polisseuse puissent être utilisés pour façonner lesdites pièces.

Un premier inconvénient de cette technique de gravure chimique est qu'elle ne permet pas de réaliser des creusures avec des flancs droits. En effet, les creusures obtenues présentent des flancs inclinés ou arrondis. On entend par là que la surface de la creusure varie en fonction de la profondeur c'est-à-dire que cette surface s'agrandit ou se rétrécit au fur et à mesure que la creusure devient profonde. Généralement cette surface rétrécit avec la profondeur. Cette constatation oblige à adapter les calculs théoriques réalisés pour obtenir des creusures à flancs droits. De plus, cette variation du profil des creusures entre la théorie et la pratique entraîne une variation des caractéristiques.

Un second inconvénient de ces techniques de gravure chimique ou d'usinage est qu'elles ne permettent pas de réaliser des structures complexes en profondeur. En effet, la gravure chimique ne permet que de réaliser des creusures en surface car l'inclinaison des flancs empêchent d'aller en profondeur. Pour l'usinage, l'utilisation d'une polisseuse et d'un foret ne permet pas non plus la réalisation de structures internes complexes. Par exemple, la réalisation d'un palier de pièce d'horlogerie en rubis monobloc c'est-à-dire composé d'une seule pierre percée d'un trou borgne est possible mais ce palier ne peut être lubrifié faute d'avoir les structures nécessaires pour stocker le lubrifiant.

### RESUME DE L'INVENTION

L'invention a pour but de réaliser une palette d'ancre comportant un évidement dont les flancs sont droits.

A cet effet, l'invention concerne un procédé de fabrication d'une palette d'ancre, le procédé étant défini dans la revendication indépendante 1 annexée. Des réalisations préférées de ce procédé sont définies dans les revendications dépendantes 2 à 6.

L'invention concerne également une palette d'ancre telle que définie dans la revendication indépendante 7 annexée.

### BREVE DESCRIPTION DES FIGURES

Les buts, avantages et caractéristiques du composant selon la présente invention apparaîtront plus clairement dans la description détaillée suivante de formes de réalisation de l'invention données uniquement à titre d'exemples non limitatifs et illustrées par les dessins annexés sur lesquels :
- Les figures 1 et 2 représentent de manière schématique un système pivot selon l'art antérieur;
- Les figures 3 à 16 et 20 représentent des exemples de réalisation de composants horlogers ne faisant pas partie de l'invention telle que revendiquée. Ces exemples ne servent que pour mieux comprendre l'invention, mais ils n'en font pas partie.
- La figure 17 représente de manière schématique une palette d'ancre connue
- La figure 18 représente de manière schématique une palette d'ancre comportant une partie des caractéristiques revendiquées ; et
- La figure 19 représente de manière schématique une palette d'ancre selon la présente invention telle que revendiquée.

### DESCRIPTION DETAILLEE

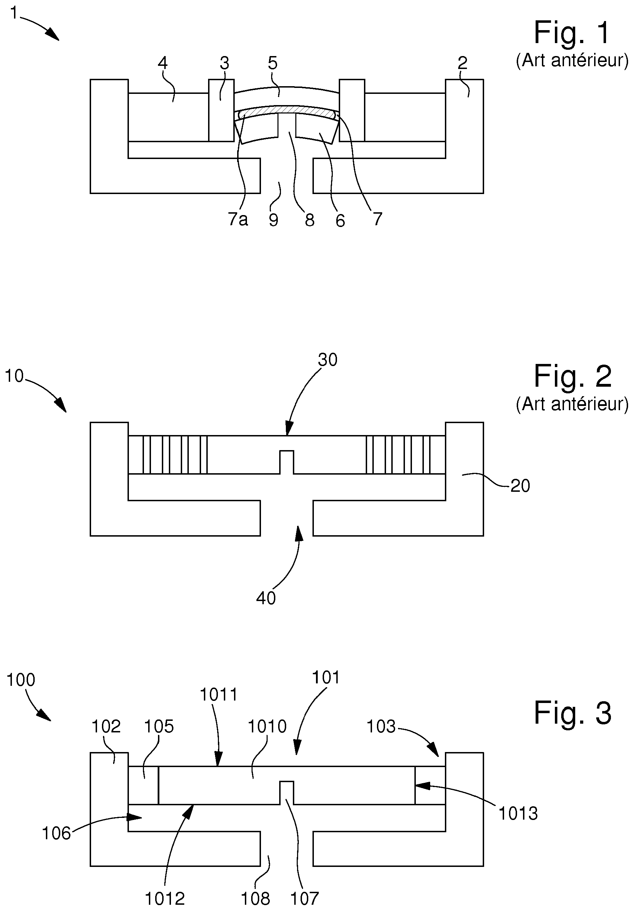

La figure 3 représente de manière schématique un composant de pièce d'horlogerie.

Dans ce premier exemple, le composant 101 est un composant de pièce d'horlogerie. Dans le cas présent, le composant 101 est un palier de pièce d'horlogerie c'est-à-dire un élément servant de pivot pour un axe de ladite pièce d'horlogerie. Ce palier 101 est une pièce d'un système pivot 100 comprenant un support 102, dont la base comporte un trou 108 pour le passage de l'axe de balancier terminé par un tigeron. Le support 102 comporte un logement 103 pour que le palier 101 puisse s'y loger. Ce palier 101 est fixé dans le logement 106 par des moyens d'attache 105. Ces moyens d'attache 105 peuvent être élastiques ou non.

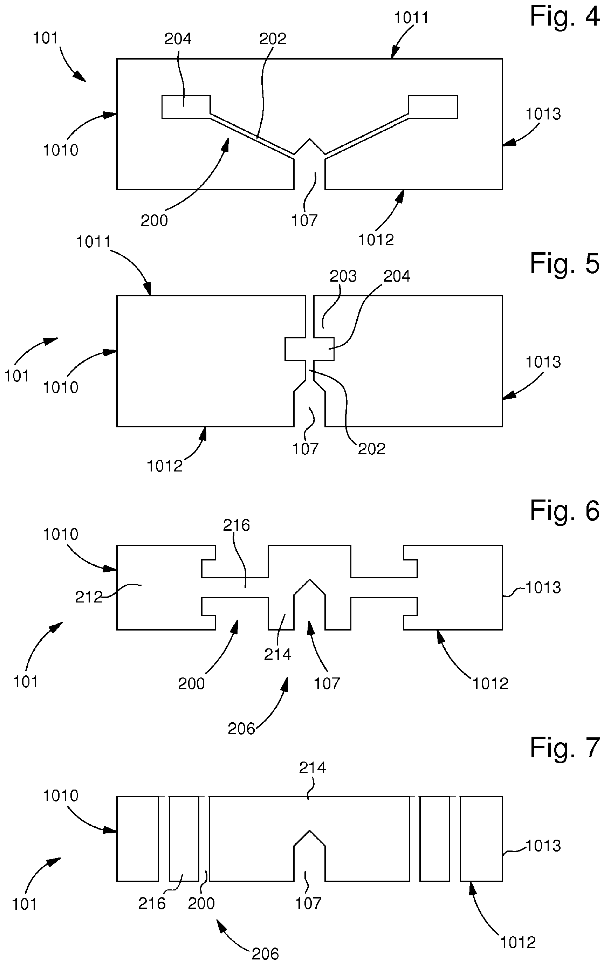

Le palier 101, selon le mode de réalisation de la figure 4, est une pièce monobloc qui se présente sous la forme d'une pièce cylindrique ou discoïdale 1010 comprenant une face supérieure 1011, une face inférieure 1012 et une paroi circulaire 1013. Ce palier comprend en outre au moins un évidement 200 situé au niveau de la face inférieure 1012. Cet évidement peut être par exemple le trou 107 dans lequel le tigeron de l'axe est inséré. Bien entendu, le palier 101 pourra avoir une forme quelconque telle qu'une forme parallélépipédique ou triangulaire ou toute autre forme possible. De même, il peut être envisagé que le composant 101 soit directement intégré dans un pont de pièce d'horlogerie. Le pont sert alors de substrat dans lequel le palier 101 est réalisé.

Pour réaliser le composant 101 et son évidement 200, on va décrire un procédé de fabrication qui est utilisé aussi pour la palette d'ancre telle que revendiquée. Dans le cas présent, l'accent sera mis sur la réalisation de l'évidement 200.

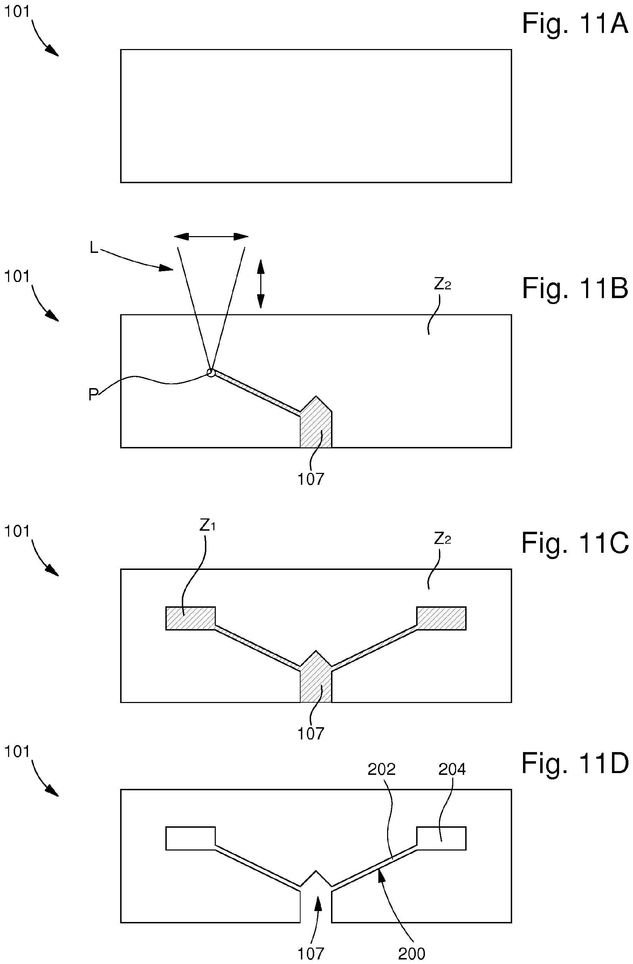

Dans une première étape représentée à la figure 11A, on se munit d'un substrat, ici le composant 101, c'est à dire le palier, sans que l'évidement 200 ne soit réalisé. On comprend alors que ce palier 101 est préalablement réalisé. Ce palier 101 est réalisé selon la méthode la plus appropriée en fonction du matériau le constituant, appelé ici premier matériau, comme par exemple l'usinage ou le polissage.

Une seconde étape consiste à se munir d'un laser (L) dont la durée des impulsions est ici de l'ordre de la femtoseconde c'est-à-dire 10⁻¹⁵ seconde (typiquement 100 fs). La durée des impulsions peut aller de la femtoseconde à la picoseconde (10⁻¹² seconde). Ce laser (L) est ensuite utilisé afin de modifier la structure dudit palier 101 comme visible à la figure 11B. A cet effet, le premier matériau est choisi comme étant transparent pour le laser. Cela permet de pointer, avec le point de focalisation (P) du laser (L), un point (P) qui peut se trouver sur ou sous la surface du palier 101. Pour le laser (L) dont la durée des impulsions est ici de l'ordre de la femtoseconde, le premier matériau peut être un matériau monocristallin comme le quartz, le saphir ou le rubis synthétique, ou un matériau polycristallin comme le rubis polycristallin ou un matériau amorphe comme un verre tel que la silice ou une céramique. Il est aussi envisageable de réaliser en composant en polymère. Le point de focalisation (P) est ensuite déplacé en direction du palier 101 au niveau de zones situées sur ou sous la surface du palier selon une structure définie à réaliser. Tout cela est fait selon une séquence prédéterminée ou désirée afin de provoquer localement une modification de la structure du matériau par absorption à plusieurs photons. En effet, la modification de la structure du matériau par absorption à plusieurs photons nécessite une densité d'énergie très élevée. Or, obtenir une telle densité d'énergie nécessaire n'est actuellement possible qu'avec des lasers dont la durée des impulsions est très faible, c'est-à-dire, de l'ordre de la femtoseconde ou de la picoseconde. Ces lasers sont, en effet, capables de fournir cette densité d'énergie au point de focalisation c'est-à-dire là ou la densité d'énergie est la plus importante. On obtient alors le palier 101 tel que visible à la figure 11C.

La troisième étape consiste à se munir d'un agent chimique. Cet agent chimique est choisi pour permettre aux zones Z1 dont la structure est modifiée d'être dissoutes plus rapidement que les zones Z2 dont la structure n'a pas été modifiée. On entend par là que la vitesse d'attaque des zones Z1 dont la structure a été modifiée par le point de focalisation (P) du laser (L) est supérieure à la vitesse d'attaque des zones Z2 dont la structure n'a pas été modifiée par le laser (L). En effet, la modification locale de la structure par le point de focalisation (P) du laser (L) femtoseconde permet de choisir un agent chimique qui est plus réactif aux zones modifiées Z1 qu'aux zones non modifiées Z2. En conséquence, en plongeant, durant un temps déterminé, ledit palier 101 dans un bain composé de l'agent chimique, on fait en sorte que toutes les zones Z1 dont la structure a été modifiée par le point de focalisation (P) du laser (L) soient dissoutes. Bien entendu, les dimensions du composant sont calculées pour prendre en compte l'attaque chimique de l'agent chimique sur les zones non modifiées et ainsi ne pas dissoudre excessivement les zones dont la structure n'a pas été modifiée. On obtient alors le palier 101 visible à la figure 11D.

Par ailleurs, on notera que pour que la dissolution des zones Z1 dont la structure a été modifiée se fasse, il est nécessaire que les zones Z1 puissent être accessibles pour l'agent chimique. On comprend donc qu'au moins une surface ou au moins une zone Z1 proche de la surface soit modifiée. En effet, le présent procédé permet de réaliser des structures internes mais le présent procédé nécessite que l'agent chimique puisse avoir accès aux zones Z1 dont la structure est modifiée. Avec une zone Z1 dont la structure est modifiée en surface, on permet audit agent chimique de dissoudre directement les zones modifiées Z1. Néanmoins, il est envisageable que les zones Z1 dont la structure a été modifiée ne soient pas situées à la surface mais juste sous la surface. L'agent chimique dissout alors le peu de zones Z2 non modifiées séparant ledit agent chimique des zones modifiées Z1 pour permettre ensuite la dissolution de celles-ci. Bien entendu, chaque évidement 200 du palier 101 devra déboucher sur une surface ou être proche d'une surface. Néanmoins, il est envisageable que les différents évidements soient reliés les uns aux autres par une surface commune de sorte que la dissolution se transmette aux différents évidements 200. Une fois toutes les zones modifiées Z1 dissoutes, ledit palier 101 est sorti du bain.

Une quatrième étape consiste à nettoyer ledit palier 101 afin que tous les résidus d'agent chimique soient éliminés de sorte que la réaction chimique soit définitivement stoppée.

Un avantage de ce procédé est qu'il est aussi bien adapté pour la petite série que pour la grande série. En effet, l'étape d'attaque chimique est adaptée autant pour la petite série de quelques substrats à la fois que pour la grand série, c'est-à-dire un grand nombre de substrats à la fois.

L'avantage de ce procédé est donc de permettre de réaliser des évidements 200 de petites tailles directement dans la structure du palier 101 ce qu'un usinage classique ne peut faire. En effet, un palier 101 de pièce d'horlogerie possède de très faibles dimensions de l'ordre du millimètre et usiner mécaniquement des évidements 200 dans la structure est trop complexe. Or, avec ce procédé, il devient aisé de creuser à l'intérieur du palier 101.

Bien entendu, on comprendra que dans le cas présent, le palier 101 sans le trou 107 dans lequel le tigeron de l'axe est inséré, peut être usiné préalablement avec des méthodes connues et que le procédé selon la présente invention est utilisé pour réaliser le trou 107 et d'autres évidements 200. Mais il est envisageable que le procédé décrit puisse être utilisé pour réaliser les évidements 200 dans un palier 101 dans lequel le trou 107 est réalisé préalablement. Il est possible que le procédé puisse être utilisé, à partir d'un substrat, pour réaliser la totalité du palier 101 directement. Celui-ci est réalisé à partir d'un substrat subissant le même procédé tel que décrit ci-dessus.

On comprendra également que le substrat dans lequel le composant 101 est réalisé peut être un pont de pièce d'horlogerie dans lequel le palier est directement intégré de sorte que l'ensemble pont et palier soit monobloc.

Dans une première variante visible aux figures 4 et 5, le trou 107, dans lequel le tigeron de l'axe est inséré, est usiné préalablement et le ou les évidements 200 réalisés par le procédé selon l'invention sont utilisés pour des applications micro fluidiques. On entend par là que cet évidement 200 est utilisé pour contenir ou permettre la circulation d'un liquide.

On comprendra donc que, pour l'exemple du palier, cet évidement 200 peut être utilisé pour stocker du lubrifiant servant à la lubrification de l'axe inséré dans le trou 107 du palier 101 par son tigeron. En effet, la lubrification permet la diminution des frottements et donc la diminution des pertes, permettant soit l'amélioration de la précision de la marche de la pièce d'horlogerie, soit l'augmentation de la réserve de marche de la pièce d'horlogerie, soit les deux. Comme expliqué précédemment, le stockage du lubrifiant sur un palier 101 composé d'une seule pierre est impossible. Avec le procédé tel que décrit ci-dessus, il est donc possible de stocker ce lubrifiant à l'intérieur de la pierre faisant office de palier 101 en créant au moins un évidement 200.

Cet évidement 200 s'étend à partir de la surface du trou 107 vers l'intérieur du palier 101. Cela permet au lubrifiant stocké dans ledit évidement 200 de pouvoir avoir accès au trou 107 et donc au tigeron à lubrifier lors de la rotation de l'axe. Cet évidement 200 est donc agencé pour stocker du lubrifiant qui pourra s'écouler vers le tigeron de l'axe.

Avantageusement, l'évidement 200 comprend au moins une cavité 204 et éventuellement au moins un canal 202. En effet, dans un espace restreint, on rapprochera ledit évidement de la surface du trou 107 pour avoir un palier 101 plus compact. Par contre, si l'espace n'est pas restreint, il est envisageable d'avoir au moins un canal pour relier le trou 107 à la cavité 204. Dans ce cas, les dimensions du canal 202 et de la cavité 204 sont calculées pour que la cavité 204 puisse stocker la quantité de lubrifiant nécessaire à la bonne lubrification du palier 101 et pour que le canal 202 puisse délivrer le lubrifiant de façon régulière et dans les quantités suffisantes. Si un seul évidement 200 avec un canal 202 et une cavité 204 n'est pas suffisant, il est possible de prévoir plusieurs évidements 200 comprenant chacun une cavité 204 et un canal 202 pour relier ladite cavité 204 au trou 107. Il est également envisageable qu'un évidement 200 puisse être composé de plusieurs cavités 204 associé chacune à un canal 202 et que les différents canaux 202 se rejoignent au niveau d'un point de jonction afin que le lubrifiant soit délivré au tigeron par une seule sortie. Il est également prévu que le canal 202 puisse présenter une pente de sorte à amener naturellement le lubrifiant depuis la cavité 204 vers le trou 107. Il peut être également prévu que l'évidement comprenne un canal de sortie 203 débouchant sur une autre surface du palier 101 pour faciliter la mise du lubrifiant dans ladite cavité 204 comme visible à la figure 5. Cette configuration permet également de faciliter la gravure par l'agent chimique ainsi que le nettoyage du palier 101.

Dans une seconde variante visible aux figures 6, 7 et 8, l'évidement 200 réalisé est utilisé pour former une structure 206 pouvant être élastique.

Selon une première forme d'exécution de cette seconde variante visible aux figures 6 et 7, la pièce cylindrique ou discoïdale 1010 comprend une partie centrale 214 reliée, par au moins un bras élastique 216, à une partie périphérique ou rebord annulaire 212 du palier 101. De préférence, la partie périphérique 212 et la partie centrale 214 ont la même hauteur. La partie centrale 214 est de forme cylindrique et présente le trou 107 dans lequel le tigeron de l'axe est inséré. Ledit au moins un bras élastique 216 peut être une lame dont la flexibilité est modifié en jouant sur les dimensions comme sur l'épaisseur. De préférence, ledit au moins un bras 216 se présente sous la forme d'un bras courbé dont l'épaisseur est égale à la hauteur de la partie centrale cylindrique 214 comme visible à la figure 7. Préférentiellement, la structure 206 comprend trois bras 216 recourbés dont les points d'attache, respectivement au rebord 212 et à la partie centrale 214, sont décalés angulairement de 120 degrés.

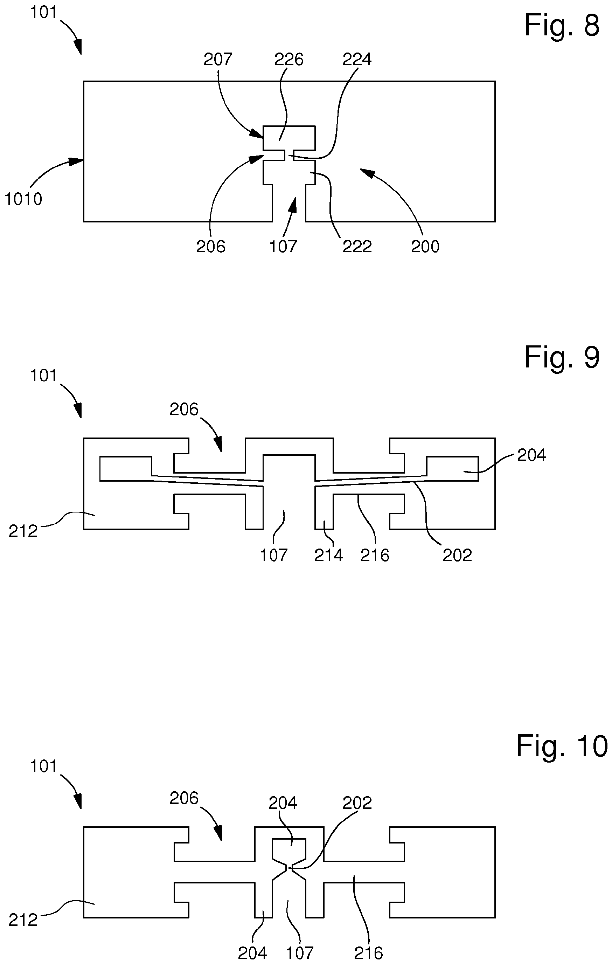

Dans une deuxième forme d'exécution de cette seconde variante visible à la figure 8, le ou les évidements 200 forment une structure 206 élastique. Cette structure 206 comprend un évidement 200 sensiblement cylindrique, pouvant être traversant ou non, et comprenant une paroi 222 à partir de laquelle s'étendent au moins deux lames 224. Ces lames 224 sont préférentiellement diamétralement opposées et s'étendent en direction du centre axial de l'évidement 207. Ces lames 224 séparent ledit évidement 200 en deux parties 107, 226. Une première partie 107 débouche sur l'extérieur du palier et est le trou 107 qui sert à accueillir le tigeron de l'axe. La seconde partie 226 de l'évidement 200 est utilisée pour le débattement des lames 224. Ces au moins deux lames 224 sont, de part leur réalisation, flexibles. Cette flexibilité est permise car ces lames 224 sont longues et fines de sorte que si l'axe bouge, son tigeron vient en contact des lames 224. Celles-ci se déforment alors sous l'effet de la contrainte appliquée par le tigeron de l'axe de sorte à faire office d'amortisseur. L'ensemble de l'évidement 200 est réalisé simultanément c'est-à-dire que le faisceau laser (L) est dirigé de sorte que le point de focalisation (P) balaye la zone définissant lesdits évidements afin de modifier la structure de cette zone. L'agent chimique se charge ensuite de dissoudre la zone définissant lesdits évidements. Préférentiellement, la seconde partie 207 comprend quatre lames 224 flexibles. Ces lames peuvent se présenter dans des plans horizontaux différents.

Une troisième variante visible aux figures 9 et 10 combine les deux variantes précédentes de sorte que le palier comprenne à la fois au moins un évidement 200 formant une structure élastique 206 mais également au moins un évidement 200 formant une cavité 204 pour le stockage d'un lubrifiant. On peut en effet prévoir que le palier 101 comprend une structure formée d'une partie centrale 214 reliée à la partie périphérique 212 du palier par au moins un bras élastique 216 afin d'amortir les chocs mais qui comprend également une cavité 204 servant de réservoir pour lubrifiant afin d'améliorer l'interaction entre ledit palier et le tigeron de l'axe. Pour cela, l'évidement 200 servant de cavité 204 de lubrifiant, peut être placé dans la partie centrale 214 de la structure 206 élastique comme visible à la figure 10. Avantageusement, cet évidement 200 est placé au-dessus du trou 107 de sorte que le lubrifiant puisse s'écouler par gravité ou capillarité dans le trou 107. Un canal 202 étroit peut être prévu pour contrôler le débit du lubrifiant. Cet évidement 200 pourra également prendre la forme d'une gorge circulaire située sur la paroi du trou 107,

Néanmoins, il peut être envisagé que le ou les évidements 200 pour le stockage d'un lubrifiant soient situés au niveau de la partie périphérique 212 dudit palier et que le lubrifiant soit amené vers le trou 107 par au moins un canal 202 comme visible figure 9. On comprend alors que le ou les canaux 202 passent par les bras élastiques 216 de la structure 206 élastique.

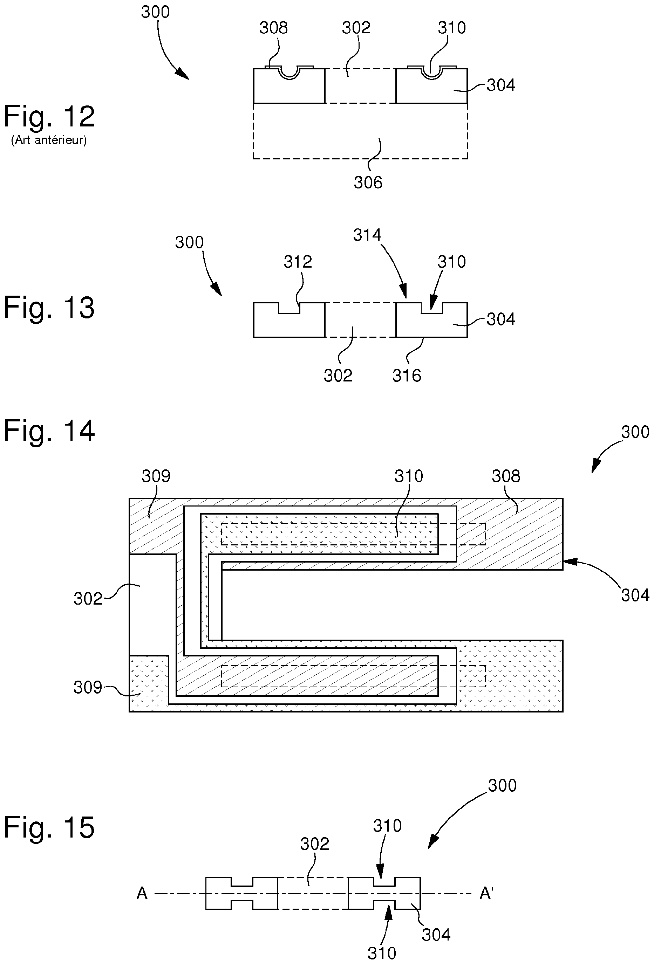

Dans un second exemple ne faisant pas partie de l'invention telle que revendiquée, le composant fabriqué avec le même procédé, utilisé aussi pour réaliser la présente invention telle que revendiquée, est un résonateur 300. Ce résonateur comporte un corps utilisé en déformation. Un résonateur classique visible aux figures 12 et 14 comprend une base 302 posée sur un socle 306 et à partir de laquelle s'étendent au moins deux bras parallèles 304. Ces deux bras parallèles portent des métallisations qui forment, sur ces branches, deux groupes d'électrodes 308 qui permettent de les soumettre à des champs électriques pour les faire vibrer. Le résonateur 300 comprend en outre, sur la base 302, des plages de connexion 309 reliées respectivement aux groupes d'électrodes 308 comme visibles à la figure 14. Chaque bras 304 comprend une face supérieure et une face inférieure.

Afin d'améliorer les caractéristiques du résonateur 300, il est connu de réaliser des gorges 310 ou rainures sur ces bras 304. Ces gorges ou rainures 310 permettent d'augmenter le couplage piézoélectrique induisant une augmentation du facteur de qualité du résonateur 300. Cette augmentation du facteur de qualité entraîne une diminution de la consommation électrique. Cette diminution de la consommation est une conséquence de la diminution de la résistance électrique représentant les pertes dans le schéma équivalent du résonateur 300.

Le procédé de fabrication peut être utilisé afin de réaliser ces gorges ou rainures 310. Dans l'exemple décrit, chaque bras 304 comprend au moins une gorge 310, située chacune sur la face supérieure du bras 304 correspondant.

Pour cela, il faut d'abord se munir du résonateur 300 avant que les électrodes ne soient faites.

Puis, le laser dont la durée des impulsions est de l'ordre de la femtoseconde est utilisé pour modifier localement la structure des bras 304. On obtient alors des zones de bras 304 dont la structure est modifiée par absorption à plusieurs photons, ces zones ayant une forme prédéfinie, de préférence parallélépipédique. Cette modification de la structure permet de rendre ces zones plus sélectives. On entend par là que ces zones sont plus réactives à certains agents chimiques que les zones non modifiées.

Cela permet par la suite d'effectuer une étape de gravure chimique.

Cette étape de gravure chimique consiste à plonger le résonateur 300 dans une solution chimique choisie pour attaquer sélectivement les zones modifiées par le laser. Néanmoins, il est possible de choisir une solution chimique qui va attaquer les zones modifiées plus rapidement que les zones non modifiées. Dans ce cas-là, les dimensions du résonateur 300 sont définies pour que l'attaque de l'agent chimique sur les zones non modifiées soit prise en compte pour ne pas altérer les dimensions finales.

Préférentiellement, dans le cas où chaque bras 304 comprend une seule rainure 310, celle-ci est placée de façon centrée au niveau des bras 304, les rainures 310 étant placées sur la même face 314.

Le procédé tel que décrit ci-dessus permet de réaliser des gorges ou rainures 310 offrant un couplage piézoélectrique plus important car ce procédé permet d'obtenir des rainures 310 avec des flancs 312 plus verticaux comme visibles à la figure 13. Or cette verticalité influe sur le couplage de manière significative.

Dans une première variante de ce second mode de réalisation visible à la figure 15, chaque face 314, 316 de chaque bras 304 comporte une gorge ou rainure 310. On comprend que pour un résonateur 300 ayant deux bras 304, ledit résonateur 300 comprend quatre rainures 310. On dénombre alors une rainure 310 sur la face supérieure 314 de chaque bras 304 et une rainure 310 sur la face inférieure 316 de chaque bras 304. Dans cette variante, les rainures 310 de chaque bras 304 sont opposées par rapport au plan A-A' visible à la figure 15.

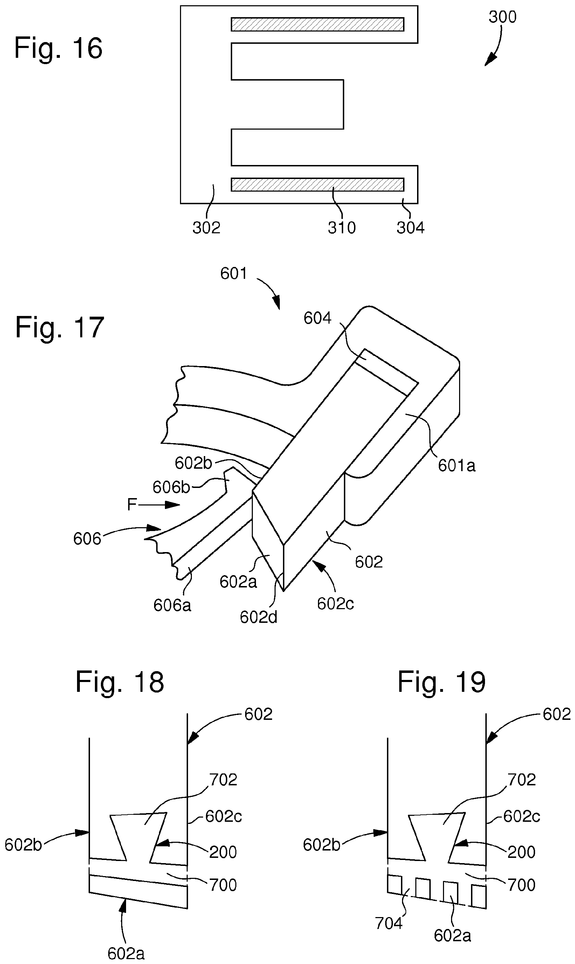

Dans une seconde variante visible à la figure 16, il est possible que le résonateur 300 comprenne un troisième bras 304 de sorte que le résonateur 300 ait une forme similaire à celle d'un trident. Ce troisième bras 304, ici central, est utilisé pour la fixation du résonateur 300 et plus particulièrement pour modifier son centre de gravité. En effet, ce troisième bras 304 est utilisé comme point de fixation de sorte qu'il soit en contact du socle 306 soutenant le résonateur 300. Cette disposition du troisième bras 304 qui fait office de bras central 304 permet de centrer le centre de gravité et d'avoir un meilleur équilibre du résonateur 300. Le procédé est alors utilisé pour réaliser ledit résonateur 300 à partir d'un substrat. La précision du procédé permet de réaliser des formes complexes. Cette possibilité de réaliser tout le résonateur 300 avec le procédé ci-dessus est avantageuse car elle permet de réaliser les contours et les rainures 310 en une seule étape. Bien entendu, cela est également possible avec un résonateur 300 standard à deux bras 304.

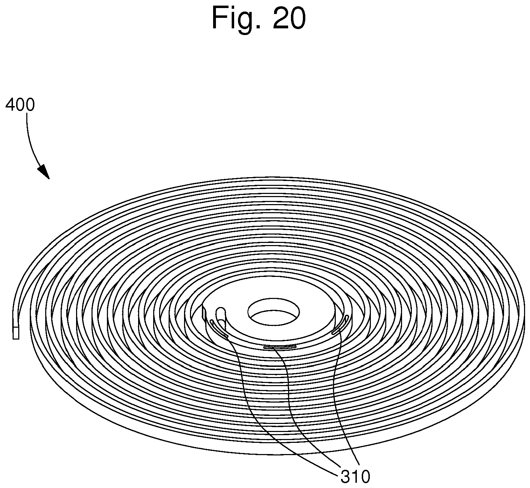

Bien entendu, on comprend que si le résonateur se présente sous la forme d'un spiral 400, au moins un évidement 200 peut être réalisé sur au moins l'une des faces dudit résonateur spiral et se présente sous la forme d'une baignoire 310 comme visible sur la figure 20.

On comprendra que cette méthode de fabrication peut être également utilisée pour réaliser d'autres pièces. On pense notamment à la réalisation de palettes d'ancre en rubis possédant au moins un évidement 200 servant de réservoir pour lubrifiant. En se référant à la figure 17, on voit une ancre 601 ayant une structure classique portant deux palettes 602 (seule la palette de sortie ayant été représentée sur la figure 17). La palette 602 est une pièce généralement en rubis dont toutes les faces sont polies et qui est chassée et collée dans un logement 604 ménagé dans le bras 601a de l'ancre 601. La palette 602 comprend un plan d'impulsion 602a, un plan de repos 602b et un plan de fuite 602c, le plan d'impulsion 602a et le plan de fuite 602c s'intersectant selon une arête de sortie ou bec d'impulsion 602d. Le plan d'impulsion 602a et le plan de repos 602b coopèrent respectivement avec les dents 606 de la roue d'échappement et plus particulièrement avec le plan de repos 606a et le bec de repos 606b des dents 606. La roue d'échappement 6 tourne de manière classique pas à pas dans le sens de la flèche F. Les points de lubrification particulièrement importants sont donc le plan d'impulsion 602a et le plan de repos 602b de sorte qu'une présence de lubrifiant entre les dents de la roue d'échappement et ces plans est nécessaire au cours des différentes phases de fonctionnement de l'échappement.

Or, actuellement, la lubrification consiste à disposer une goutte de lubrifiant sur les dents de la roue d'échappement ce qui ne permet pas d'assurer une lubrification sur une longue durée dans la mesure où le lubrifiant est chassé rapidement vers le plan de repos 602b de la palette 602 sur lequel il s'accumule, de sorte qu'il n'est plus disponible pour la lubrification souhaitée.

La présente invention, telle que revendiquée, règle ce problème en permettant de réaliser un évidement 200 se présentant sous la forme d'au moins un canal 700 et au moins un réservoir 702 pour stocker ledit lubrifiant. Pour cela, la méthode précédemment décrit est utilisée.

La palette visible à la figure 18, se présente sous la forme d'une palette 602 comprend un canal principal 700 reliant le plan de fuite 602c audit plan de repos 602b. La palette 602 comprend en outre un évidement 200 servant de réservoir 702 situé dans la palette 602 et communiquant avec le canal principal 700. Ce réservoir 702 s'étend dans une direction parallèle au plan de fuite 602c et au plan de repos 602b et tendant à l'éloigner du plan d'impulsion 602a. Ce réservoir 702 est dimensionné pour stocker la totalité du lubrifiant nécessaire. Lors du fonctionnement de l'échappement, du lubrifiant est, par capillarité, aspiré dans le canal principal 700 pour sortir au niveau du plan de repos 602b.

Selon l'invention telle que revendiquée, la palette 602 comprend en outre des canaux secondaires 704 s'étendant depuis ledit canal principal 700 et débouchant sur le plan d'impulsion 602a corne visibles à la figure 19. Ces canaux secondaires 704 servent, par conséquent, à permettre la lubrification du plan d'impulsion 602a, la lubrification de l'échappement étant alors améliorée.

La présence de ce réservoir pour stocker la totalité du lubrifiant directement dans la palette 602 permet de s'affranchir du problème d'éjection du lubrifiant en cas de choc.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

## Revendications

1. **Procédé de fabrication d'une palette d'ancre** dans un matériau transparent **à la longueur d'onde d'**un laser (101, 300)), ladite palette étant destinée à coopérer **avec les dents d'une roue d'échappement d'un mouvement d'horlogerie, cette palette** comprenant **un plan de fuite (602c), un plan de repos (602b) et un plan d'impulsion** (602a), le procédé comprenant
une étape consistant à se munir dudit substrat (101, 300) et aussi les étapes suivantes :
a) modifier par laser **la structure d'au moins une zone** du matériau transparent afin de rendre plus sélective ladite au moins une zone en étant une dite au moins une zone qui est plus réactive à certains agents chimiques que la ou les zones non modifiées dudit matériau ;
b) graver chimiquement ladite au moins une zone afin de sélectivement fabriquer :
- **au moins un évidement (200) formé d'au moins un canal principal (700) reliant** ledit plan de fuite (602c) au plan de repos (602b), et **d'au moins** un réservoir (702) communiquant avec ledit canal de sorte que la totalité du lubrifiant nécessaire puisse être stockée dans ledit au moins un canal principal et ledit réservoir (702), et
- au moins un canal secondaire (704) dans ladite au moins une zone du matériau transparent devant relier ledit au moins un canal principal (700) au plan **d'impulsion (602a), ledit évidement** (200) étant utilisé pour contenir ou permettre la circulation du lubrifiant, ledit évidement débouchant sur une surface du matériau transparent

2. Procédé de fabrication selon la revendication 1, **caractérisé en ce que** la durée des impulsions du laser (L) vont de la femtoseconde à la picoseconde.

3. **Procédé de fabrication selon l'une des revendications** 1 ou 2, **caractérisé en ce que** le matériau transparent est réalisé en matériau monocristallin.

4. **Procédé de fabrication selon l'une des revendications** 1 ou 2, **caractérisé en ce que** le matériau transparent est réalisé en matériau polycristallin.

5. **Procédé de fabrication selon l'une des revendications** 1 ou 2, **caractérisé en ce que** le matériau transparent est réalisé en polymère.

6. **Procédé de fabrication selon l'une des revendications** 1 ou 2, **caractérisé en ce que** le matériau transparent est réalisé en un matériau amorphe comme une céramique ou un verre.

7. Palette (602) **d'ancre** (601) **destinée à coopérer avec les dents d'une roue** d'**échappement d'un mouvement d'horlogerie, ladite palette comprenant un plan de** fuite (602c), un plan de repos (602b) **et un plan d'impulsion** (602a) et au moins un canal principal (700) reliant le plan de fuite (602c) audit plan de repos (602b), ladite palette comprenant:
- un évidement (200) formé **d'**au moins un canal principal (700) reliant le plan de fuite (602c) audit plan de repos (602b), et **d'au moins** un réservoir (702) communiquant avec ledit canal de sorte que la totalité du lubrifiant nécessaire puisse être stockée dans ledit au moins un canal principal et ledit réservoir, et
- au moins un canal secondaire (704) reliant ledit au moins un canal principal au **plan d'impulsion,**
la palette étant **caractérisée en ce que** l'agencement dudit réservoir et dudit canal dans la palette est configuré de sorte que ledit lubrifiant compris dans ce réservoir est aspiré par capillarité dans le canal principal (700) pour sortir au niveau du plan de repos (602b).

## Patentansprüche

1. Herstellungsverfahren einer Ankerpalette aus einem transparenten Material mit einer Wellenlänge eines Lasers (101, 300), wobei die Palette dazu bestimmt ist, mit den Zähnen eines Hemmrads eines Uhrwerks zusammenzuwirken, wobei diese Palette eine Entweichungsebene (602c), eine Lagerebene (602b) und eine Impulsebene (602a) umfasst, wobei das Verfahren einen Schritt, der daraus besteht, sich mit dem Substrat (101, 300) zu versehen, und außerdem die folgenden Schritte umfasst:
a) ein Modifizieren durch den Laser der Struktur von mindestens einer Zone des transparenten Materials, um diese mindestens eine Zone selektiver zu machen, indem diese mindestens eine Zone eine Zone ist, die reaktiver auf bestimmte chemische Wirkstoffe ist als die nicht modifizierte(n) Zone(n) des Materials;
b) ein chemisches Gravieren der mindestens einen Zone, um selektiv Folgendes herzustellen:
- mindestens eine Aussparung (200), die aus mindestens einem Hauptkanal (700), der die Entweichungsebene (602c) mit der Lagerebene (602b) verbindet, und mindestens einem Behälter (702), der mit dem Kanal so verbunden ist, dass die Gesamtheit des notwendigen Schmiermittels in dem mindestens einen Hauptkanal und dem Behälter (702) gespeichert werden kann, gebildet ist, und
- mindestens einen Sekundärkanal (704) in der mindestens einen Zone aus transparentem Material zum Verbinden mit dem mindestens einen Hauptkanal (700) mit der Impulsebene (602a), wobei die Aussparung (200) verwendet wird, um das Schmiermittel zu enthalten oder seine Zirkulation zuzulassen, wobei die Aussparung auf eine Fläche aus transparentem Material mündet.

2. Herstellungsverfahren nach Anspruch 1, **dadurch gekennzeichnet, dass** die Dauer der Laserimpulse (L) von Femtosekunde zu Pikosekunde reicht.

3. Herstellungsverfahren nach einem der Ansprüche 1 oder 2, **dadurch gekennzeichnet, dass** das transparente Material aus monokristallinem Material ausgeführt ist.

4. Herstellungsverfahren nach einem der Ansprüche 1 oder 2, **dadurch gekennzeichnet, dass** das transparente Material aus polykristallinem Material ausgeführt ist.

5. Herstellungsverfahren nach einem der Ansprüche 1 oder 2, **dadurch gekennzeichnet, dass** das transparente Material aus Polymer ausgeführt ist.

6. Herstellungsverfahren nach einem der Ansprüche 1 oder 2, **dadurch gekennzeichnet, dass** das transparente Material aus einem amorphen Material ausgeführt ist, wie einer Keramik oder einem Glas.

7. Palette (602) eines Ankers (601), die dazu bestimmt ist, mit den Zähnen eines Hemmrads eines Uhrwerks zusammenzuwirken, wobei die Palette eine Entweichungsebene (602c), eine Lagerebene (602b) und eine Impulsebene (602a) und mindestens einen Hauptkanal (700), der die Entweichungsebene (602c) mit der Lagerebene (602b) verbindet, umfasst, wobei die Palette Folgendes umfasst:
- eine Aussparung (200), die aus mindestens einem Hauptkanal (700), der die Entweichungsebene (602c) mit der Lagerebene (602b) verbindet, und mindestens einem Behälter (702), der mit dem Kanal so verbunden ist, dass die Gesamtheit des notwendigen Schmiermittels in dem mindestens einen Hauptkanal und dem Behälter gespeichert werden kann, gebildet ist, und
- mindestens einen Sekundärkanal (704), der den mindestens einen Hauptkanalmit mit der Impulsebene verbindet,
wobei die Palette **dadurch gekennzeichnet ist, dass**
die Anordnung des Behälters und des Kanals in der Palette so konfiguriert ist, dass das in diesem Behälter enthaltene Schmiermittel durch Kapillarwirkung in den Hauptkanal (700) gesogen wird, um im Bereich der Lagerebene (602b) auszutreten.

## Claims

1. Method for manufacturing a pallet-stone from a material transparent at the wavelength of a laser (101, 300), said pallet-stone being intended to cooperate with the teeth of an escape wheel of a timepiece movement, this pallet-stone comprising an escape plane (602c), a locking plane (602b) and an impulse plane (602a), the method comprising a step consisting in procuring said substrate (101, 300) and also the following steps:
a) modifying by laser the structure of at least one region of the transparent material in order to make said at least one region more selective while being a said at least one region that is more reactive to certain chemical agents than the non-modified region or regions of said material;
b) chemically etching said at least one region in order to selectively manufacture:
- at least one recess (200) formed by at least one main channel (700) connecting said escape plane (602c) to the locking plane (602b), and at least one reservoir (702) communicating with said channel so that all of the necessary lubricant can be stored in said at least one main channel and said reservoir (702), and
- at least one secondary channel (704) in said at least one region of the transparent material that is to connect said at least one main channel (700) to the impulse plane (602a), said recess (200) being used for containing or allowing the circulation of lubricant, said recess emerging on a surface of the transparent material.

2. Manufacturing method according to claim 1, **characterised in that** the pulse duration of the laser (L) ranges from a femtosecond to a picosecond.

3. Manufacturing method according to one of claims 1 or 2 **characterised in that** the transparent material is made of single-crystal material.

4. Manufacturing method according to one of claims 1 or 2, **characterised in that** the transparent material is made of polycrystalline material.

5. Manufacturing method according to one of claims 1 or 2, **characterised in that** the transparent material is made of polymer.

6. Manufacturing method according to one of claims 1 or 2 **characterised in that** the transparent material is made of an amorphous material such as a ceramic or a glass.

7. Pallet-stone (602) of pallets (601) intended to cooperate with the teeth of an escape wheel of a timepiece movement, said pallet-stone comprising an escape plane (602c), a locking plane (602b) and an impulse plane (602a) and at least one main channel (700) connecting the escape plane (602c) to said locking plane (602b), said pallet-stone comprising
- a recess (200) formed by at least one main channel (700) connecting the escape plane (602c) to said locking plane (602b), and at least one reservoir (702) communicating with said channel so that all of the necessary lubricant can be stored in said at least one main channel and said reservoir (702), and
- at least one secondary channel (704) connecting said at least one main channel to said impulse plane
the pallet-stone being **characterised in that** the arrangement of said reservoir and of said channel in the pallet-stone is configured so that said lubricant included in this reservoir is sucked by capillarity into the main channel (700) so as to leave at the locking plane (602b).
